# EUROPEAN PATENT APPLICATION

(11) **EP 4 451 002 A1**
(43) Date of publication of application: **23.10.2024**
(21) Application number: 23305606.8
(22) Date of filing: 19.04.2023
(51) Int. Cl.: G01S 7/282, G01S 7/35, G01S 7/40, G01S 13/931

(54) **RADAR POWER CALIBRATION WITH COMPENSATION FOR DISSIPATED POWER**

(71) Applicant: NXP B.V., 5656 AG Eindhoven (NL)
(72) Inventor: El Ozeir, Mohamad, 31023 Toulouse Cedex 1 (FR); Goumballa, Birama, 31023 Toulouse Cedex 1 (FR); Saadi, Ahmed Abdelhalim, 31023 Toulouse Cedex 1 (FR)
(74) Representative: Schmütz, Christian Klaus Johannes

(57) **Abstract**

A first input signal that corresponds to an output transmitted signal of a power amplifier of a vehicle radar system is received and the output power level of the transmitted signal is calibrated to a desired magnitude of the transmitted signal; the proposed calibration method and apparatus allows to improve both the output power calibration accuracy and the power amplifier power consumption across the dynamic range of output power levels, by reducing dissipated power of the power amplifier in correlation with reduced output power levels. The calibration method includes controlling voltage generators that drive cascode amplifiers in the signal chain: a low dropout regulator is controlled to generate supply and cascode voltages that produce the desired power output level; and, a current digital-to-analog converter is controlled to generate an optimal biasing current under the supply and cascode voltage conditions.

## Description

### TECHNICAL FIELD

The embodiments of the present disclosure relate to radar systems and methods of their operation and, more specifically, to systems and methods for calibrating a power level of an output signal of a vehicle radar system.

### BACKGROUND

A radar system transmits an electromagnetic signal and receives back reflections of the transmitted signal. The time delay and/or doppler shift between the transmitted and received signals can be determined and used to calculate the distance and/or the speed of objects causing the reflections. For example, in automotive applications, radar systems can be used to determine the distance and/or the speed of oncoming vehicles and other obstacles.

To ensure proper operation of a vehicle radar system it can be desirable to calibrate the power of the electromagnetic signals being transmitted by the system to a desired power level. A typical calibration procedure can involve several stages of electronic components cooperating to adjust the power level; ultimately, the goal is for the radar transmitter to emit signals at a power level as close as possible to the target power level. Ensuring an accurate output power is very important for the radar performance and adherence to safety standards in automotive radar applications. For example, some countries restrict maximum output power to a certain level, and calibration allows the radar system to satisfy the restriction.

Additionally, the efficiency of the radar transmitter during and after output power calibration is crucial in various transmitter applications, in order to overcome thermal budget constraints at the radar sensor level. One factor having a significant impact on efficiency is the internal dissipated power of transmitter components, including the power calibration section; dissipation increases the overall power consumption of the transmitter without improving the transmitted signal. Hence, ensuring efficient internal power control is very important for the system performance. In some newer (e.g., high dynamic range) applications of the radar transmitter, it may be desirable to calibrate the output power to one or more power levels that are below the maximum desired output power level. It would be advantageous to maintain the efficiency of the transmitter at lower output power levels by controlling power dissipation to reduce overall power consumption of the transmitter.

### SUMMARY

This disclosure provides a system and method for optimizing the operation of a radar device, such as a vehicle radar system, by accurately calibrating the output power of a radar transmitter to a target level at the antenna reference plane (ARP), at target output power levels that are significantly below the maximum target output power. Specifically, the system and method may be configured to adjust the output power of the power amplifier and/or the buffer chain (and, consequently the signals transmitted by the radar device) to reach a target power level and signal current density that compensates for dissipated power in the radar transmitter.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 is a block diagram depicting functional components and calibrated power measurements for a radar transmitter in a radar system.
FIG. 2 is a circuit diagram depicting functional components of a radar transmitter in accordance with this disclosure.
FIG. 3 is a flowchart depicting an example method for radar output power calibration with dissipated power compensation, in accordance with this disclosure.
FIG. 4A is a flowchart depicting example method for determining an optimal setting for supply voltage in a power calibration process, in accordance with this disclosure.
FIG. 4B is a flowchart depicting another example method for determining an optimal setting for biasing currents in a power calibration process, in accordance with this disclosure.

### DETAILED DESCRIPTION

It will be readily understood that the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

For simplicity, the described features, advantages, and characteristics of the invention are described throughout this specification may be described as being implemented within a radar transmitter disposed on a printed circuit board or other substrate, and including integrated circuits as well as individual circuit components and other pieces of electronic equipment, but the present devices and methods may be implemented in other transmission systems and devices suitable for use in vehicle and otherwise-portable radar systems.

In general, the embodiments described herein provide for calibration of a radar system's transmit power to a target level lying anywhere within the dynamic range of the transmitter output power with greater accuracy and efficiency by decreasing dissipated power within the transmitter for lower output power levels. The systems and methods disclosed herein resolve drawbacks in existing calibration techniques that use a maximum desired output power *Pmax* as a sole benchmark: when the target output power is lower than *Pmax,* but the dissipated power within the radar transmitter circuitry is allowed to remain constant, the power consumption of the transmitter does not decrease proportionally with the output power level. Consequently, the **efficiency** of the transmitter is degraded at lower output power levels. An efficiently effective calibration procedure for the output power at levels below *Pmax* is needed.

Embodiments of the systems and methods herein use a peak-to-peak detector to monitor the output power level while the controller adjusts control signals for power-consuming components of the power calibration section of the radar transmitter. In particular, the controller generates a code for controlling a low dropout (LDO) voltage regulator to produce a corresponding supply voltage for amplifiers in the signal chain; when these amplifiers have a cascode topography, the supply voltage is also provided to a cascode voltage generator that generates a cascode voltage for the common gate of the amplifiers. Meanwhile, the controller also generates a code for controlling a current source, such as a current digital-to-analog converter (DAC), to produce a biasing current for the cascode amplifier common source. A two-stage calibration technique includes setting the DAC code to maximum biasing current and then sweeping the set of LDO code values to determine the LDO code that corresponds to a calibrated power level; then, with the supply and cascode voltages set by the calibrated LDO code, the set of DAC code values is tested (e.g., using a binary search algorithm) to find the DAC code that causes the maximum power output level. As such, the embodiments of the present disclosure can provide improved operation of a vehicle radar system with more precise power level control and less calibration overhead. A further feature of the present systems and methods is that they are adaptable to compensate for variations in both load and antenna/transmitter packages.

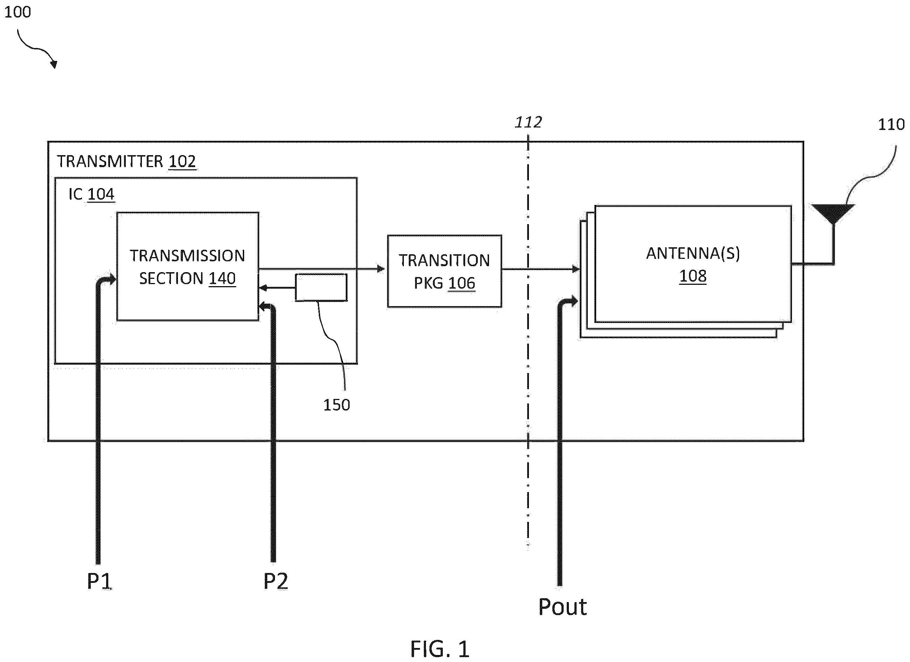

FIG. 1 illustrates an example vehicle radar system 100 in accordance with the present disclosure (when incorporated into a vehicle, vehicle radar system 100 may sometimes be referred to as a vehicle radar subsystem). Vehicle radar system 100 includes at least one radar transmitter 102, and may include additional apparatus that are not pictured, such as one or more radar receivers, controllers and control circuitry, system integration packages, and the like. The radar transmitter 102 may include an integrated circuit 104, such as a system-on-chip, that comprises the radar transmitter's 102 native transmission circuitry, described further below. The radar transmitter 102 may further include a transition package 106 comprising circuitry that enables installation of one or more antennas 108 (e.g., internal antennas and/or external antennas 110, and connection components) into the radar transmitter 102. The transition package 106 thus may serve as an interface between the native transmission circuitry (i.e., within the integrated circuit 104 created and installed by the radar transmitter 102 manufacturer) and the aftermarket circuitry (i.e., antenna(s) 108 and connection components installed by the manufacturer's customer).

The integrated circuit 104 includes a transmission signal section 140 comprising circuitry for producing a transmission signal at a controllable output power level. Generally, this circuitry may include a suitable microcontroller as well as suitable input and output buffers, voltage regulators, power amplifiers, couplers, peak-to-peak detectors (PPDs) and other detectors/sensors, and the like. The integrated circuit 104 further includes one or more power measurement devices 150 for measuring output power. The measurement devices 150 may provide feedback signals to the transmission signal section 140 (i.e., to a microcontroller) for the purpose of performing the calibration procedures herein. The measurement devices 150 may be any suitable sensor or detector arrangement that can be configured to measure characteristics of the output signal, such as current, voltage, etc.

This disclosure pertains to calibration of the output power of the transmission signal delivered from the transmission signal section 140 to the transition package 106 and from the transition package 106 to the antenna(s) 108. The transmission signal path intersects the ARP 112, represented for simplicity by a dotted line disposed between the transition package 106 and the antenna(s) 108. The ARP 112 is located, in physical space, a fixed distance from the signal output of the transmission signal section 140 (e.g., from an output port of a power amplifier). The output power is calibrated relative to the ARP 112, however the power characteristics cannot be measured precisely at the location of the ARP 112 and are instead measured indirectly by the measurement devices 150 in the integrated circuit 104.

, The transmission signal section 140 amplifies an input power level P1 to produce a transmission signal with a power level P2 so that the transmission signal arrives at the antenna(s) 108 with a desired output power level Pout. The output power calibration process determines control settings to cause the power amplifier to increase the magnitude so the output power level P2 matches a target power level Pcal. In ideal conditions, the magnitude of amplifier gain A needed to calibrate the output power level is A = Pcal - P1. However, in practice the calibration process may also account for resistive loss, thermal loss, and/or other causes of unwanted power dissipation within the transmission section 140, in order to maintain efficient operation of the integrated circuit 104. To demonstrate this process, a maximum desired output power level Pmax is used as a reference (i.e., Pcal = Pmax). When P2 = Pmax, both the amplifier gain magnitude A and magnitude d of the power dissipation are also at their highest. If a lower target power level Pcal = Pmax - x is selected, less amplifier gain is required to calibrate P2 to Pcal; if the magnitude d of dissipated power remains constant, power is being wasted in the transmission section 140. Consequently, without method for reducing the dissipated power, efficiency of an output power calibration steadily worsens as the target output power level is lowered from maximum.

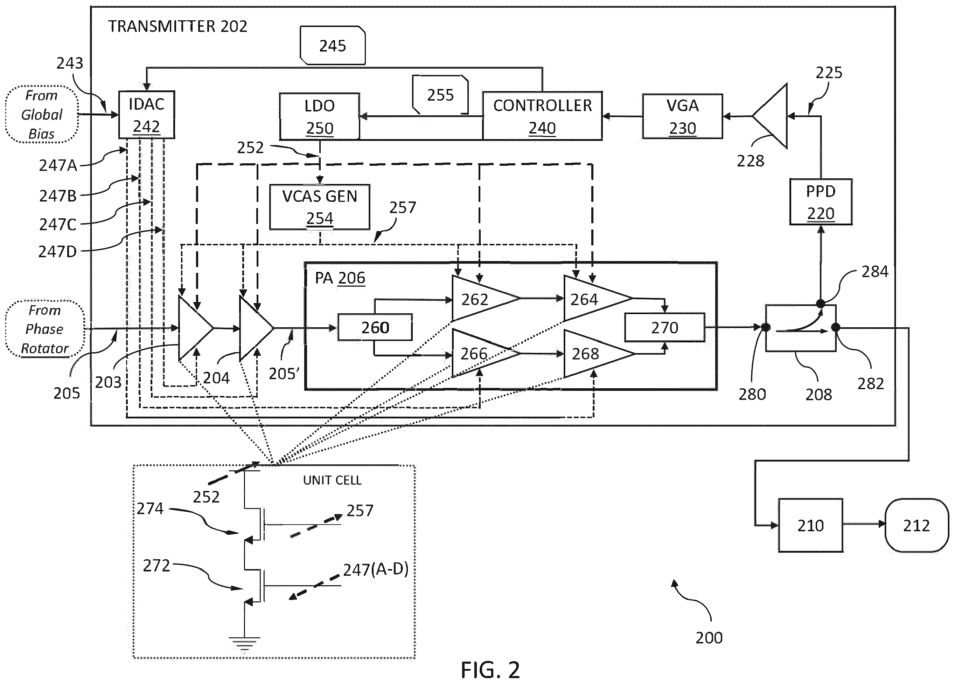

FIG. 2 illustrates an example embodiment of a radar transmitter 200, such as the radar transmitter 102 of FIG. 1. The radar transmitter 200 may include an output power calibration section 202 configured to deliver an input signal to the antenna with a power level that is calibrated to result in the transmitted signal having the desired output power. In various embodiments, the output power calibration section 202 may be implemented in one or more integrated circuits, as described above. Within the output power calibration section 202: a buffer section comprising one or more input and output buffers 203, 204 receives calibrated input power 205 from another component of the output signal chain, such as a phase rotator, and provides a buffered input power signal 205' to an input of a power amplifier 206; the power amplifier 206 outputs the received signal 205' with an amplified output power; a coupler 208 receives the output of the power amplifier 206, and outputs the corresponding transmission signal from the output power calibration section 202 to a transition package 210 as described above. In turn, the transmission signal passes to the ARP 212.

Power amplifier 206 may be the power amplifier of a vehicle radar system being calibrated (e.g., a power amplifier implemented within radar transmitter 102 of FIG. 1). Power amplifier 206 is configured to generate an amplified electromagnetic signal (e.g., a radar signal) that is output by power amplifier 206 as a transmitted signal. The output signal generated by power amplifier 206 is, effectively, the transmission signal; as such, a magnitude of the signal output by power amplifier 206 is the same as (or directly related to) the magnitude of the signal that will ultimately be output or transmitted by (a) transmit antenna(s) of the vehicle's radar system. In an example of the power amplifier 206, the input power signal 205' is received at a signal splitter 260 comprising circuitry to split an input signal into parallel signal channels: a first split signal is passed to a first driver 262 and output stage 264 combination; and, a second split signal is passed to a second driver 266 and output stage 268 combination. The drivers 262, 266 amplify the split signals, providing current and power gain in proportion to the amount of supply voltage. The outputs of the drivers 262, 266 are inputs to the output stages 264, 268, which provide further power gain of the input signal. A power combiner 270 receives the amplified split signals and combines them back into an amplified representation of the calibrated input power 205; the amplified signal is the output of the power amplifier 206, delivered to the input port 280 of the coupler 208.

In one or more embodiments, the coupler 208 is a suitable directional coupler(s) or a bi-directional coupler including at least one input port and at least one output port connected in the signal transmitter path. For example, the coupler 208 may receive the power amplifier 206 output signal at an input port 280 and conduct the signal over a first transmission line (not shown) to an output port 282 electrically connected to the transition package 210. A coupled port 284 of the coupler 208 is coupled to the first transmission line such that a part of the signal received at the input port 280 and output at the output port 282 is also output at the coupled port 284. The coupler 208 may also be a dual directional coupler, with both a forward-coupled port and a reverse-coupled port each terminated to an internal load.

The coupler 208 may be implemented in any suitable manner so as to couple a portion of the differential output signal of power amplifier 206 into the power calibration mechanism of the radar transmitter 200. In various embodiments, the coupler 208 may be connected at any points in the transmit signal path of power amplifier 206 to the antenna (through ARP 212) or to any other power amplifiers in which the amplifier's output power level is to be calibrated. An example embodiment is shown in FIG. 2, in which a detector 220 is electrically connected to the coupled port 284 and may be alternatively referred to herein as the "coupled detector." The detector 220 may, in some embodiments, serve as the measurement device 150 or as a component thereof, as described above with respect to FIG. 1. The detector 220 may produce a measurement 225 of the incident power based on the coupler 208 output signal received as input.

The detector 220 may be any suitable power sensor(s) that produce output signals representing their corresponding power measurements, for use in the calibration procedure. In some embodiments, the detector 220 may be a PPD that produces an output voltage corresponding to the input to the PPD. Thus the detector 220 in electrical communication with the coupled port 284 of the coupler 208 may be configured to convert the coupled portion of the output signal of power amplifier 206 to a direct-current (DC) signal 225 having a magnitude that is equal to or proportional to, or otherwise a function of, the magnitude of the peaks of the coupled portion. The DC signal 225 from the detector 220 may passed to one or more buffers 228 and then to one or more variable-gain amplifiers (VGA) 230. The VGA 230 is configured to amplify a DC input signal into a full-scale signal with minimum values equal to or approximately equal to a ground level and maximum values equal to or approximately equal to a power supply voltage of VGA 230. The amplified output signal of the detector 220 is then passed to a controller 240.

The controller 240 may be any suitable microcontroller or other computing device capable of performing the calibration procedures described herein. In particular, the controller 240 may be configured to receive the detector's 220 amplified output signals and analyze them to determine the measured incident power levels. Further, the controller 240 may be configured to output control signals that cause a change in one or more voltages supplied to components of the power amplifier 206, which in turn adjusts the power amplifier 206 output signal toward a desired (i.e., calibrated) output power level. Control logic may be stored in memory (not shown) of the controller 240 and executed by the controller 240 to perform the calibration procedures described herein. Such memory may also store data elements that are critical to performing power level calculations or to tracking code values in connection with the calibration processes, as described further herein. In some embodiments, such as the illustrated radar transmitter 200 of FIG. 2, the controller 240 receives the output signals of the detector 220; these signals may, for example, be voltages, such as when the detector 220 is a PPD. The controller 240 may be configured to convert these output signals into measurements of incident power at the ARP 212. While other data elements may be stored according to various implementations, in the illustrated example device 200, the data elements that will be used by the controller include: values for the coupling factor, directivity, isolation, and insertion loss of the coupler 208; a value for insertion loss of the transition package 210; and, the input-power-to-output-voltage transfer function of the PPD. Using these values, the controller 240 may execute a model for transforming the received PPD output voltages into measured power levels at the PPD's input, and the measured power levels to measurements of incident power at the ARP 212.

In various implementations, the controller 240 outputs control signals to control the operation of the power amplifier 206. A biasing device 242 may be in electrical communication with one or more output ports of the controller 240, and also with one or more components of the power amplifier 206. In some embodiments, the biasing device 242 may provide a biasing current to one or more components in the buffer section and/or the power amplifier 206 gain section(s). For example, as illustrated, the biasing device 242 may provide one or more programmable biasing currents 247A, 247B, 247C, 247D to each of the input buffers 203, 204 of the buffer section and to each of the amplifiers 262-268 in both channels of the gain section of the power amplifier 206. A biasing current magnitude affects the amount of voltage and/or current gain, power gain, impedance fidelity, and other characteristics of the component to which it is supplied, ultimately affecting the power amplifier 206 output as well. In some embodiments, the biasing device 242 may be a current digital-to-analog converter ("IDAC") that receives, as digital values: a global bias setting 243 that represents a normalized biasing current for a system (e.g., a vehicle radar subsystem); and, a control signal identifying one of a range of possible magnitudes of the IDAC's output current(s), which in turn provide the biasing current(s) 247A-D. The biasing device 242 may receive a control signal from the controller 240 and may adjust the biasing current(s) 247A-D accordingly. For example, where the biasing device 242 is an IDAC with multiple (e.g., four) output channels, the IDAC may be programmed to read from the control signal a code 245 selected from a set of possible codes, referred to herein as "DAC codes," corresponding to discrete output current levels within the IDAC's range, for each of the output channels; the IDAC then adjusts the biasing currents 247A-D to match the values associated with the received DAC code 245.

A voltage regulator 250, such as a low drop-out regulator ("LDO") may be in electrical communication with one or more output ports of the controller 240, and also with one or more components of the power amplifier 206. In some embodiments, the voltage regulator 250 may provide a supply voltage 252 to components in the buffer section and/or the power amplifier 206 gain section(s). For example, as illustrated, the voltage regulator 250 provides a supply voltage 252 to each of the input buffers 203, 204 of the buffer section and to each of the amplifiers 262-268 in both channels of the gain section of the power amplifier 206. The supply voltage 252 value affects the amount of voltage and/or current gain, power gain, impedance fidelity, and other characteristics of the power amplifier 206 output. The voltage regulator 250 may receive a control signal from the controller 240 and may adjust the supply voltage 252 accordingly. In some embodiments, the voltage regulator 250 is a LDO programmed to read from the control signal a code 255 selected from a set of possible codes, referred to herein as "LDO codes," corresponding to discrete supply voltages within the LDO's range; the LDO then adjusts the supply voltage 252 to match the value associated with the received LDO code 255.

In some embodiments, any or all of the op amp components, including the input buffers 203, 204 and the amplifiers 262-268 of the power amplifier 206 gain section(s), may be a cascode amplifier. A cascode amplifier is a two-stage amplifier in which a common source stage feeds a common gate stage. FIG. 2 illustrates a unit cell of a cascode amplifier connected to voltage sources in accordance with the present disclosure. The unit cell is powered by the supply voltage 252 of the voltage regulator 250. The unit cell includes a common source transistor 272 that is driven by (i.e., receives at the gate of the source transistor 272) the corresponding biasing current 247A-D; the source transistor 272 is connected at its drain terminal to the source terminal of a gate transistor 274 that receives at its gate a third voltage, referred to herein as the "cascode voltage 257." The cascode voltage 257 is generated by a voltage generator 254 connected to the voltage regulator 250 and connected in parallel to the gate lines of the cascode amplifiers. The voltage generator 254 may receive the supply voltage 252 from the voltage regulator 250 and may convert it into the cascode voltage 257. For example, the voltage generator 254 may be configured to subtract a preset offset voltage from the supply voltage 252 to produce the cascode voltage 257. Therefore, the cascode voltage 257 is determined by the LDO code as well. Consequently, the LDO code is used to control the supply voltage 252 and the cascode voltage 257 and the DAC code is used to control the biasing current(s) 247A-D. In various embodiments of the transmitter 200, cascode amplifiers in the signal chain may comprise a progressively greater number of unit cells (i.e., input buffer 203 at the start of the chain has the fewest unit cells, and amplifiers of the output stages 264, 268 have the most unit cells); consequently, under uniform input current (e.g., a corresponding biasing current 247A-D), the current density within the op amps decreases progressively along the signal chain.

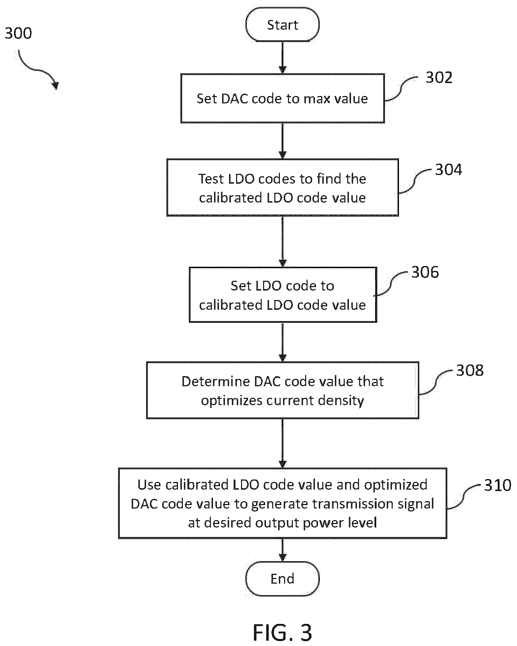

According to various embodiments, a transmitter of a radar system, such as the radar transmitter embodiments described above, may perform calibration procedures to produce a transmission signal that is calibrated to optimize signal quality at the transmission antenna, at any output power level within the output range of the power amplifier; power compensation of the calibration procedure is minimized without sacrificing accuracy of the calibration. Referring to FIG. 3, an example method 300 of calibrating output power may be performed by a controller, such as a microprocessor executing control logic instructions to measure input signals and generate control signals as outputs. In some embodiments, the control logic for generating control signals may further include stored data that the controller may access in order to produce a control signal readable by the component to receive the control signal. For example, the stored data may include lookup tables identifying sets of codes that the component(s) can read in order to execute its own control logic.

Thus, at 302, the controller may begin the calibration method 300 by selecting, as the DAC code to transmit to the IDAC, a maximum value of the DAC code. For example, the IDAC may be configured with a set of 32 DAC codes (e.g., codes 0 to 31) each corresponding to a selectable analog biasing current that the IDAC is able to output; in some embodiments, the values (measured in, e.g., microamps) increase incrementally by DAC code. Setting the DAC code to its maximum value may cause the controller to send a control signal comprising the DAC code to the IDAC, configuring the IDAC to output the maximum biasing current(s) and thus impart the maximum biasing current upon the connected cascode amplifiers.

At 304, the controller may determine the setting for the voltage regulator (and, correspondingly, the cascode voltage generator) that causes the power amplifier, under the maximum biasing condition, to emit its output signal at the target output power level. For example, the voltage regulator may be a LDO configured with a set of 21 digital LDO codes (e.g., codes 0 to 20) each corresponding to a selectable analog supply voltage that the LDO is able to output; in some embodiments, the values (measured in, e.g., volts or millivolts) of the supply voltage increase incrementally by LDO code. In one embodiment of determining the setting, the controller determines the LDO code that instructs the LDO to output the supply voltage level that causes the power amplifier to produce its output signal at the target output power level. For example, the controller may "sweep" the set of LDO codes and monitor the results: starting at the minimum/lowest LDO code, the controller causes the LDO to output the corresponding supply voltage and then measures the detector's (e.g., a coupled PPD) output signal to determine the resulting output power level; the controller then selects the next adjacent LDO code and repeats the process, until a selected LDO code produces the target output power level. At 306, the controller may select this code as the calibrated LDO code and may use the calibrated LDO code to control the voltage regulator and the voltage generator for the rest of the calibration procedure and in operation.

At 308, the controller may determine which of the DAC codes optimizes current density of the common source within the cascode amplifiers when the supply voltage and cascode voltage correspond to the calibrated LDO code. In some embodiments, the supply voltage, cascode voltage, and biasing current are delivered to each of the op amps in the signal chain with the same magnitude; since the size of the conductive regions in the amplifiers also remains constant, the current density may be inferred from the change in power consumption of the amplifiers as the DAC code is changed. As in step 304 for the calibrated LDO code, the controller may "select and test" codes from the set of DAC codes. In some embodiments, in order to optimize the duration and power consumption of this step 308, the controller may iterate through the set of DAC codes using a suitable search function, such as by "sweeping" the set of DAC codes as in step 304 or by performing a binary search of the set of DAC codes as described further below.

In various embodiments, the optimal DAC code is that which causes the output power level of the power amplifier to best match the target calibrated power level, while also causing the lowest possible (i.e., the lowest of any of the DAC codes in the set of DAC codes) power consumption/dissipation within the transmitter circuitry. To determine the effect of the selected DAC code on the output power level, the controller may read the output signal of the detector (e.g., PPD) as described above with respect to step 304. The controller may determine the power consumption based on the known output current(s) (measured in, e.g., amps or milliamps) of the IDAC. At 310, with the optimal LDO code and DAC code selected, the controller may complete the calibration process. In some embodiments, the controller may store the determined optimal values for the LDO code and the DAC code in memory, which may be internal to the controller and/or an external memory device accessible by the controller. For example, the determined optimal values may be stored in one or more registers, comprising either transient or persistent data storage; in some embodiments, the register(s) may be accessible by the controller or other computing components programmed to use the optimal values for other applications besides the described power calibration process. Additionally or alternatively, the controller may generate a signal indicating to the radar subsystem that the output power has been calibrated. The controller then controls the buffer stage and amplification stage to generate the transmission signal at the desired output power level, by delivering the calibrated LDO code to the LDO and the optimized DAC code to the biasing device.

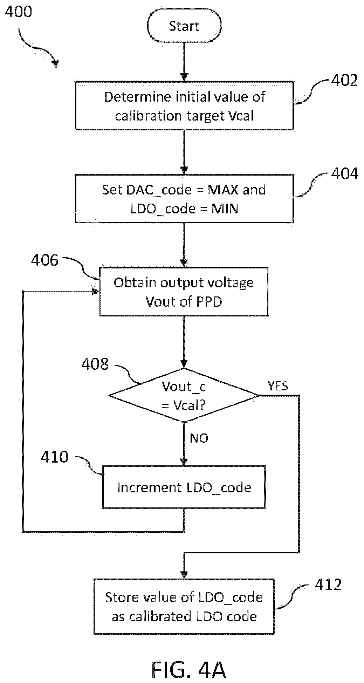

FIG. 4A illustrates an example method 400 for determining the optimal LDO code for output power calibration. While other methods may be suitable, the method 400 of "sweeping" the LDO code performed by a controller as described above may proceed as follows. At 402, the controller may determine a target calibration voltage *Veal* representing a connected PPD's output voltage that corresponds to the target output power level *Pout.* For example, the controller may access memory that stores a lookup table for the selected PPD's output signal correlations to the measured input signal of the PPD. It will be understood that the present calibration techniques may be implemented to calibrate the power amplifier to any desired power level *Pout* within the dynamic range of the power amplifier.

Upon determining *Vcal,* at 404 the controller may send control signals for initiating calibration to the IDAC and, simultaneously or subsequently, to the LDO. The value for the DAC code may be the maximum value in the IDAC's set of DAC codes, causing the IDAC to output a maximum biasing current to the subsystem's op amps. The initial value for the LDO code may be the minimum, or lowest, value in the LDO's set of LDO codes. This initial setting allows the controller to increment, or "sweep," through the available codes as described below.

At 406, the controller may obtain an output signal of a detector, such as a coupled PPD as described above, produced by the PPD while the power amplifier output signal has the output power level associated with the present DAC code and LDO code values. That is, at the first pass, the output signal is a measurement of the output power level when the DAC code is set to the maximum value and the LDO code is set to the minimum value. For example, the controller may receive an amplified output signal of a PPD coupled to the coupled port of a bi-directional coupler that receives the output signal of a power amplifier as input; the controller may determine an output voltage *Vout* or output current of the coupled PPD; this value is proportional to the coupled signal, i.e., a sample of the signal on the coupler's transmission line, which in turn is proportional to the power amplifier output. At 408, the controller may determine whether the present output voltage *Vout* matches the target calibration voltage *Vcal.* If not, at 410 the controller may increment the LDO code - that is, may select the next sequentially higher value of the set of LDO codes - and send the new value of the LDO code to the LDO. The controller then returns to step 406 and again tests the PPD output signal to determine if *Veal* has been reached; steps 406-410 are repeated until at 408 the controller determines that *Veal* has been reached. Upon determining that *Vout* matches *Veal,* at 412 the controller may store the present value of the LDO code as the calibrated LDO code. It will be understood that the iterated steps 406-410 are performed while the DAC code is held at its maximum value.

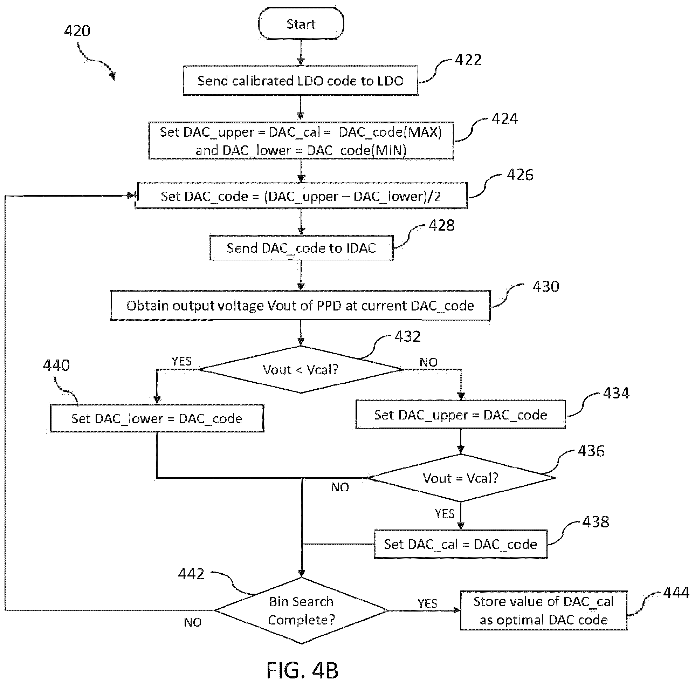

FIG. 4B illustrates an example method 420 for determining the optimal DAC code for output power calibration. In some embodiments, the optimal DAC code is the DAC code that, of the set of available DAC codes, causes the IDAC to output a biasing current that produces the highest output power level when the LDO is producing a supply voltage based on the calibrated LDO code. Alternatively, the optimal DAC code may be the DAC code that causes the IDAC to output the lowest magnitude biasing current(s) (or, summed current of the set of biasing currents) that still produces the desired output power level. In any of the described embodiments, the method 420 may successfully identify an optimal DAC code that produces the desired output power level but achieves lower power consumption than the maximum DAC code; power management and signal quality efficiencies are thus realized by improving the correlation of dissipated power to incident power within the transmitter. While other methods may be suitable, the method 420 of performing a binary search of the DAC code performed by a controller as described above may proceed as follows. In some embodiments, the method 420 may be initiated once the method 400 of finding the calibrated LDO code, described in FIG. 4A, is complete; thus, at 422, the controller may first transmit the calibrated LDO code to the LDO, causing the LDO to output the optimal supply voltage to the op amps and to the cascode voltage generator. At 424, the controller may initialize one or more variables for tracking the iterations of testing DAC codes for optimal performance. For example, the initialization selects the maximum and minimum values in the set of DAC codes to serve as the initial upper and lower bounds of a binary search of the set of DAC codes; additionally, the value of the optimal DAC code (*DAC_cal* in the Figures) may initially be set to the maximum value, to be potentially updated as described below.

At 426, the controller may select a first DAC code from the set of DAC codes for testing. In the example method 420 that operates using a binary search, the first DAC code to be tested may have the value between the minimum and maximum available values in the set of DAC codes, i.e., the maximum value divided by two. For example, if the set of DAC codes is represented by an array of 31 digital values, the maximum value is represented by array element 30, the minimum value is represented by array element zero, and the first value to be tested at step 426 is selected as array element 15. At 428, the controller sends the selected DAC code to the IDAC to cause the IDAC to produce the corresponding biasing current(s) applied to the buffer section and amplification section components.

At 430, the controller may obtain the output signal of the detector (e.g., output voltage *Vout* of the coupled PPD as described above) produced while the power amplifier output signal has the output power level associated with the present DAC code and LDO code values. That is, at the first pass, the output signal is a measurement of the output power level when the DAC code is set to the value (MAX/2) and the LDO code is set to the calibrated LDO code value.

At 432, the controller may determine whether the measured output voltage *Vout* is less than the target voltage *Veal* described above with respect to FIG. 4A. If the present value *Vout* is not smaller, at 434 the upper bound of the active binary search region may be decreased to the value of the present DAC code. At 436, the controller may determine whether the measured value *Vout* is equal to the target voltage *Vcal*; if so, this means the present DAC code is the most optimal code yet tested, and at 438 the controller may store the presently selected DAC code as the calibrated DAC code (overwriting the value previously stored as the calibrated DAC code). The controller then proceeds to step 442. If at step 432 the controller determines that the present value *Vout* is smaller than the target voltage *Veal,* at 440 the controller increases the lower bound of the active binary search region to the value of the present DAC code, and then proceeds to step 442. It will be understood that in response to the outcome of the comparison step 432, the controller may store a flag or other indicator of the outcome (e.g., assign a value of 0 if *Vout* is smaller than *Veal,* and a value of 1 if *Vout* is greater or equal).

At 442, the controller determines whether the binary search is complete. The binary search is complete if the controller has iterated the binary search algorithm to the bottom of the binary search tree. For example, in a standard half-interval binary search, each successive iteration of the process will select the DAC code that is at the midpoint of the interval between two boundary array elements, until the interval is less than two; at this point, the search algorithm is complete. If at 442 the controller determines that the binary search is complete, at 444 the controller stores the DAC code presently stored as the calibrated DAC code as the final calibrated DAC code and the method 420 ends.

If the binary search is not complete, the controller may continue to search for a DAC code that more efficiently calibrates the output power level by, for example, returning to step 426 to select and test the next DAC code. The controller may use a binary search or other suitable search algorithm to select the next DAC code value for testing. A suitable search algorithm is one that accounts for both time to complete and power consumption of the calibration process. It is contemplated that variants of a binary search will identify the optimal DAC code in less time than a "sweep" or linear search, and also will consume less power because fewer DAC codes are tested before the search resolves. A typical "half interval" binary search is described herein but shall not be considered limiting with respect to variants of binary search algorithms. In one example, at each iteration of the search, the controller: i) determines whether the current DAC code should be the new lower or upper boundary of the search interval

(e.g., the current DAC code is the new lower boundary if the flag stored at step 432 is 0, and is the new upper boundary if the flag is 1); ii) determines the interval between the current lower and upper boundary elements selected from an ordered array of DAC codes; and, iii) selects as the next DAC code the DAC code that is at the array element located at the midpoint of the interval. The controller may send the newly selected DAC code to the IDAC to cause the IDAC to update the biasing current setting(s).

The present disclosure describes various implementations of a radar transmitter in a radar system, and of a power amplifier output power calibration procedure that accounts for power dissipation within the radar transmitter. In some aspects, the disclosure provides a system for a vehicle radar subsystem. The system includes: a power amplifier configured to generate an output signal at an output terminal of the power amplifier, the power amplifier receiving a supply voltage and at least a first biasing current of one or more biasing currents; a detector electrically connected to the output terminal of the power amplifier and configured to produce a detector signal that corresponds to a power level of the output signal; and, a controller in electrical communication with the power amplifier and the detector. The controller is configured to execute control logic that causes the controller to: control the one or more biasing currents to a maximum magnitude within a range of magnitudes; while the one or more biasing currents are at the maximum magnitude, control the supply voltage within a range of values to determine, based on the detector signal, a calibrated value of the supply voltage that causes the power level to equal a target output power; control the supply voltage to the calibrated value; while the supply voltage is applied to the power amplifier at the calibrated value, control the one or more biasing currents within the range of magnitudes to determine, based on the detector signal, one or more calibrated magnitudes each corresponding to one of the one or more biasing currents such that applying each of the one or more biasing currents at the corresponding calibrated magnitude, while the supply voltage has the calibrated value, causes the power level of the output signal to equal the target output power and a sum of the one or more calibrated magnitudes is less than any other sum of magnitudes of the one or more biasing currents that causes the power level to equal the target output power; and, control the supply voltage to the calibrated value and the one or more biasing currents to the one or more calibrated magnitudes while the power amplifier is producing the output signal.

To control the supply voltage within the range of values to determine the calibrated value, executing the control logic may further cause the controller to generate a control signal that controls the supply voltage and, until the detector signal has a measured value that corresponds to the target output power, iteratively: receive the detector signal; determine the measured value from the detector signal; determine from the measured value a differential between the power level of the output signal and the target power level; update a value of the control signal to cause the supply voltage to be adjusted in accordance with reducing the differential; and, when the measured value corresponds to the target output power, store the value of the control signal as a calibrated control signal value, wherein controlling the supply voltage to the calibrated level includes generating the control signal having the calibrated control signal value. The system may further include a low drop-out (LDO) voltage regulator electrically connected to the controller and to the power amplifier, the voltage regulator configured to receive the control signal from the controller and, responsively, generate the supply voltage corresponding to the value of the control signal and provide the supply voltage to the power amplifier. The control signal may be an LDO code, the value may be one of a set of sequential values for the LDO code, and executing the control logic may further cause the controller to: first generate the control signal with a minimum value of the set of sequential values; and, to update the value of the control signal, increment the value to a next value in the set of sequential values. The power amplifier may include one or more cascode amplifiers each having a common source transistor receiving one of the one or more biasing currents at a gate of the common source transistor and a common gate transistor having a source terminal connected to a drain terminal of the common source transistor, the common gate transistor receiving a cascode voltage at a gate of the common gate transistor; the system may further include a cascode voltage generator electrically connected to the LDO voltage regulator and to the one or more cascode amplifiers, the cascode voltage generator receiving the supply voltage and generating the cascode voltage based on the supply voltage.

The one or more biasing currents may be controlled using a control signal; to control the one or more biasing currents to a maximum magnitude, executing the control logic further causes the controller to generate the control signal having a maximum value of a sequenced set of values for the control signal. To control the one or more biasing currents within the range of magnitudes to determine the one or more calibrated magnitudes, executing the control logic causes the controller to perform a search algorithm of the set of values to determine a calibrated control signal value by iteratively, until the search algorithm completes: generating the control signal having a test value selected from the set of values; receiving the detector signal; determining, based on the measured value from the detector signal, the power level of the output signal; if the power level is equal to the target output power, storing the test value as the calibrated control signal value; if the power level is lower than the target output power, executing the search algorithm to obtain from the set of values an untested value that is higher than the test value, to use as the test value in the next iteration; and, if the power level is not lower than the target output power, executing the search algorithm to obtain from the set of values an untested value that is lower than the test value, to use as the test value in the next iteration. The system may further include a current digital-to-analog converter ("IDAC") electrically connected to the controller and to the power amplifier, the IDAC configured to receive the control signal from the controller and, responsively, generate the one or more biasing currents each at a corresponding magnitude indicated by the value of the control signal, wherein the control signal is a DAC code and the set of values are sequentially arranged, and wherein the search algorithm is a binary search of the set of values for the DAC code.

The system may further include a buffer section electrically connected to an input terminal of the power amplifier, the buffer section configured to receive a calibrated power signal and provide the calibrated power signal to the power amplifier for amplification to produce the output signal, the buffer section include one or more input buffers and one or more output buffers each receiving the supply voltage and one of the one or more biasing currents, wherein the one or more input buffers, the one or more output buffers, and the power amplifier each comprise one or more cascode amplifiers each comprising: a common source transistor receiving one of the one or more biasing currents at a gate of the common source transistor; and, a common gate transistor having a source terminal connected to a drain terminal of the common source transistor, the common gate transistor receiving a cascode voltage at a gate of the common gate transistor, wherein the cascode voltage is equal to the supply voltage minus an offset voltage. The system may further include: a low-dropout (LDO) voltage regulator electrically connected to the controller, the buffer section, and the power amplifier, the LDO voltage regulator configured to receive a first control signal from the controller and, responsively, generate the supply voltage corresponding to a value of the first control signal and provide the supply voltage to the one or more input buffers, the one or more output buffers, and the power amplifier; a cascode voltage generator electrically connected to the LDO voltage regulator, the buffer section, and the power amplifier, the cascode voltage generator configured to receive the supply voltage, generate the cascode voltage based on the supply voltage, and provide the cascode voltage to the one or more cascode amplifiers of each of the one or more input buffers, the one or more output buffers, and the power amplifier; and, a current digital-to-analog converter ("IDAC") electrically connected to the controller, to the buffer section, and to the power amplifier, the IDAC configured to receive a second control signal from the controller and, responsively, generate the one or more biasing currents each at a corresponding magnitude indicated by a value of the second control signal and provide the one or more biasing currents to the one or more cascode amplifiers of each of the one or more input buffers, the one or more output buffers, and the power amplifier. The first control signal may be a LDO code having a corresponding set of values, and the controller may be configured to determine a calibrated LDO code that causes the LDO voltage regulator to produce the supply voltage at the calibrated value by sequentially testing the set of values for the LDO code, starting at a minimum value of the set of values. The second control signal may be a DAC code having a corresponding set of values, and the controller may be configured to determine a calibrated DAC code that causes the IDAC to produce the one or more biasing currents at the corresponding one or more calibrated magnitudes by testing the set of values for the DAC code using a binary search algorithm. The system may further include memory accessible by the controller and storing the control logic, the target output power, a first set of values for the first control signal, and a second set of values for the second control signal, and the controller may be configured to obtain the corresponding values of the first and second control signals from the memory.

The detector may be a peak-to-peak detector (PPD), and the system further include a coupler electrically connected to the output terminal of the power amplifier and to an input terminal of the PPD, the coupler configured to output: at an output port of the coupler, a second output signal that corresponds to the first output signal; and at a coupled port of the coupler, a coupled output signal corresponding to a coupled portion of the first output signal coupled within the coupler, the coupled output signal also corresponding to an amount of incident power at an antenna reference plane (ARP) of the vehicle radar subsystem, wherein the detector is electrically connected to the coupled port of the coupler, and is configured to produce the detector signal responsive to the coupled output signal power level.

In another aspect, the present disclosure provides a system including a power calibration section of a radar transmitter, and a controller in electrical communication with the power calibration section. The power calibration section may be configured to control one or both of a power amplifier of the radar transmitter and a buffer section comprising one or more buffers of an input signal to the power amplifier to produce a transmission signal. The power calibration section may include: a detector electrically disposed to sample a first output signal at an output terminal of the power amplifier, the detector configured to produce a detector signal corresponding to a power level of the first output signal; a voltage regulator electrically connected to one or more amplifiers each disposed in one of the power amplifier and the buffer section, the voltage regulator configured to receive a first control signal and to provide, to the one or more amplifiers, a supply voltage at a voltage level corresponding to a value of the first control signal; and, a current source electrically connected to the one or more amplifiers, the current source configured to receive a second control signal and to provide, to the one or more amplifiers, one or more biasing currents each at a corresponding magnitude indicated by a value of the second control signal. The controller may be configured to execute control logic that causes the controller to: generate the second control signal having a first value that causes the current source to generate the one or more biasing currents each with a maximum magnitude; while the one or more biasing currents are at the maximum magnitude, iteratively test a plurality of predetermined values for the first control signal to determine, based on the detector signal, a first calibrated value that corresponds to the power level of the first output signal being equal to a target power level; generate the first control signal having the first calibrated value; and, while the supply voltage is being generated at the voltage level corresponding to the first calibrated value, iteratively test a plurality of predetermined values for the second control signal to determine, based on the detector signal, a second calibrated value that both causes the power level of the first output signal to equal the target power level, and corresponds to a sum of the corresponding magnitudes of the one or more biasing currents being less than any other sum of magnitudes of the one or more biasing currents that causes the power level of the first output signal to equal the target power level.

Each of the one or more amplifiers may be a cascode amplifier, and the power calibration section may further include a cascode voltage generator electrically connected to the voltage regulator and configured to receive the supply voltage and to provide to the one or more amplifiers a cascode voltage comprising the supply voltage minus an offset voltage. The voltage regulator may be a low dropout (LDO) voltage regulator and the first control signal may be an LDO code, and to iteratively test the plurality of values for the first control signal, the controller tests the plurality of values sequentially beginning with a minimum value for the LDO code. The current source may be a current digital-to-analog converter (IDAC) and the second control signal may be a DAC code, and to iteratively test the plurality of values for the second control signal, the controller performs a binary search of the plurality of values for the DAC code.

In another aspect, the present disclosure provides a method of calibrating output power of a power amplifier that amplifies an input signal to produce an output signal, the method including the steps of: providing, by a controller in signal communication with a voltage regulator and a current source each electrically connected to one or more amplifiers disposed in a signal chain between the input signal and the output signal, a first control signal having a first value to the current source, the current source being configured to receive the first control signal and to provide, to the one or more amplifiers, one or more biasing currents each at a corresponding magnitude indicated by a value of the first control signal, the first value indicating a corresponding maximum magnitude for each of the one or more biasing currents; while the one or more biasing currents are at the corresponding maximum magnitude, determining, by the controller, a calibrated value for a second control signal readable by the voltage regulator to provide, to the one or more amplifiers, a supply voltage at a voltage level corresponding to a value of the second control signal, the calibrated value being associated with the voltage level of the supply voltage that causes the output signal to have a power level equal to a target power level; providing, by the controller, the second control signal with the calibrated value to the voltage regulator; while the voltage regulator is providing the supply voltage at the voltage level corresponding to the calibrated value of the second control signal, determining, by the controller, a second value for the first control signal that both causes the power level of the output signal to equal the target power level, and corresponds to a sum of the corresponding magnitudes of the one or more biasing currents being less than any other sum of magnitudes of the one or more biasing currents that causes the power level of the output signal to equal the target power level; and providing, by the controller, the first control signal with the second value to the current source and the second control signal with the calibrated value to the voltage regulator. The voltage regulator may be a low-dropout (LDO) voltage regulator, the value of the second control signal is selectable from a set of LDO code values ordered sequentially by increasing associated voltage level, and determining the calibrated value for the second control signal may include iteratively, starting from the value of the second control signal set to a minimum value of the set of LDO code values and until the calibrated value is stored: providing the second control signal to the voltage regulator; obtaining, from a detector in signal communication with the controller and electrically disposed to sample the output signal at an output terminal of the power amplifier, a detector signal corresponding to the power level of the output signal; determining, based on the detector signal, whether the power level is equal to the target power level; responsive to a determination that the power level is equal to the target power level, storing the value of the second control signal as the calibrated value; and, responsive to a determination that the power level is not equal to the target power level, incrementing the value of the second control signal.

The current source may be a current digital-to-analog converter (DAC) that receives the first control signal at a digital input port and outputs the one or more biasing currents at a corresponding number of output ports. The value of the first control signal may be selectable from a set of DAC code values ordered sequentially by increasing summed magnitude of the one or more corresponding magnitudes of the one or more biasing currents, the first value being a maximum value of the set of DAC code values, and determining the second value for the first control signal may include performing a binary search of the set of DAC code values by, beginning with a lower bound of the binary search set to a minimum value of the DAC code values and both the second value and an upper bound of the binary search set to the maximum value of the DAC code values, and until the binary search is complete, iteratively: obtaining, from the set of DAC code values, a test value that is halfway between the lower bound and the upper bound; providing the first control signal having the test value to the current DAC; obtaining, from a detector in signal communication with the controller and electrically disposed to sample the output signal at an output terminal of the power amplifier, a detector signal corresponding to the power level of the output signal; determining, based on the detector signal, whether the power level is lower than the target power level; responsive to a determination that the power level is lower than the target power level, setting the lower bound to the test value; responsive to a determination that the power level is not lower than the target power level, setting the upper bound to the test value and determining whether the power level is equal to the target power level; and, responsive to a determination that the power level is equal to the target power level, resetting the second value to the test value.

Although the invention(s) is/are described herein with reference to specific embodiments, various modifications and changes can be made without departing from the scope of the present invention(s), as set forth in the claims below. Accordingly, the specification and figures are to be regarded in an illustrative rather than a restrictive sense, and all such modifications are intended to be included within the scope of the present invention(s). Any benefits, advantages, or solutions to problems that are described herein with regard to specific embodiments are not intended to be construed as a critical, required, or essential feature or element of any or all the claims.

Unless stated otherwise, terms such as "first" and "second" are used to arbitrarily distinguish between the elements such terms describe. Thus, these terms are not necessarily intended to indicate temporal or other prioritization of such elements. Similarly, the description may refer to a left-hand or right-hand bit in any series of bits (e.g., a DAC code or LDO code). It should be understood that such terms are utilized to provide a clear description of an implementation of the invention and that the various bit sequencing may be implemented in any order in memory and, in fact, the multiple bits making up a given code or other word could be implemented in different regions of a memory or across multiple different memory devices. Similar, the present description may describe a stored binary value being set when having a signal value greater than a threshold and cleared when the cell's signal value is less than that threshold. It will be apparent to the person of ordinary skill in the art that such definitions may be reversed so that a particular cell may be set when its signal value falls below a threshold and the cell is cleared when its value falls above the same or a different threshold.

The term "coupled" is defined as connected, although not necessarily directly, and not necessarily mechanically. The terms "a" and "an" are defined as one or more unless stated otherwise. The terms "comprise" and any form of comprise, such as "comprises" and "comprising"), "have" (and any form of have, such as "has" and "having"), "include" (and any form of include, such as "includes" and "including") and "contain" (and any form of contain, such as "contains" and "containing") are open-ended linking verbs. As a result, a system, device, or apparatus that "comprises," "has," "includes" or "contains" one or more elements possesses those one or more elements but is not limited to possessing only those one or more elements. Similarly, a method or process that "comprises," "has," "includes" or "contains" one or more operations possesses those one or more operations but is not limited to possessing only those one or more operations.

## Claims

1. A system for a vehicle radar subsystem, the system comprising:
a power amplifier configured to generate an output signal at an output terminal of the power amplifier, the power amplifier receiving a supply voltage and at least a first biasing current of one or more biasing currents;
a detector electrically connected to the output terminal of the power amplifier and configured to produce a detector signal that corresponds to a power level of the output signal; and
a controller in electrical communication with the power amplifier and the detector, the controller configured to execute control logic that causes the controller to:
control the one or more biasing currents to a maximum magnitude within a range of magnitudes;
while the one or more biasing currents are at the maximum magnitude, control the supply voltage within a range of values to determine, based on the detector signal, a calibrated value of the supply voltage that causes the power level to equal a target output power;
control the supply voltage to the calibrated value;
while the supply voltage is applied to the power amplifier at the calibrated value, control the one or more biasing currents within the range of magnitudes to determine, based on the detector signal, one or more calibrated magnitudes each corresponding to one of the one or more biasing currents such that:
applying each of the one or more biasing currents at the corresponding calibrated magnitude, while the supply voltage has the calibrated value, causes the power level of the output signal to equal the target output power; and
a sum of the one or more calibrated magnitudes is less than any other sum of magnitudes of the one or more biasing currents that causes the power level to equal the target output power; and
control the supply voltage to the calibrated value and the one or more biasing currents to the one or more calibrated magnitudes while the power amplifier is producing the output signal.

2. The system of claim 1, wherein to control the supply voltage within the range of values to determine the calibrated value, executing the control logic further causes the controller to:
generate a control signal that controls the supply voltage;
until the detector signal has a measured value that corresponds to the target output power, iteratively:
receive the detector signal;
determine the measured value from the detector signal;
determine from the measured value a differential between the power level of the output signal and the target power level;
update a value of the control signal to cause the supply voltage to be adjusted in accordance with reducing the differential; and
when the measured value corresponds to the target output power, store
the value of the control signal as a calibrated control signal value; and
wherein controlling the supply voltage to the calibrated level comprises generating the control signal having the calibrated control signal value.

3. The system of claim 2, further comprising a low drop-out (LDO) voltage regulator electrically connected to the controller and to the power amplifier, the voltage regulator configured to receive the control signal from the controller and, responsively, generate the supply voltage corresponding to the value of the control signal and provide the supply voltage to the power amplifier, and wherein:
the control signal is an LDO code and the value is one of a set of sequential values for the LDO code; and
executing the control logic further causes the controller to:
first generate the control signal with a minimum value of the set of sequential values; and
to update the value of the control signal, increment the value to a next value in the set of sequential values.

4. The system of claim 3, wherein:
the power amplifier comprises one or more cascode amplifiers each comprising:
a common source transistor receiving one of the one or more biasing currents at a gate of the common source transistor; and
a common gate transistor having a source terminal connected to a drain terminal of the common source transistor, the common gate transistor receiving a cascode voltage at a gate of the common gate transistor; and
the system further comprises a cascode voltage generator electrically connected to the LDO voltage regulator and to the one or more cascode amplifiers, the cascode voltage generator receiving the supply voltage and generating the cascode voltage based on the supply voltage.

5. The system of claim 1, wherein the one or more biasing currents are controlled using a control signal and:
to control the one or more biasing currents to a maximum magnitude, executing the control logic further causes the controller to generate the control signal having a maximum value of a sequenced set of values for the control signal; and
to control the one or more biasing currents within the range of magnitudes to determine the one or more calibrated magnitudes, executing the control logic causes the controller to perform a search algorithm of the set of values to determine a calibrated control signal value by iteratively, until the search algorithm completes:
generating the control signal having a test value selected from the set of values;
receiving the detector signal;
determining, based on the measured value from the detector signal, the power level of the output signal;
if the power level is equal to the target output power, storing the test value as the calibrated control signal value;
if the power level is lower than the target output power, executing the search algorithm to obtain from the set of values an untested value that is higher than the test value, to use as the test value in the next iteration; and
if the power level is not lower than the target output power, executing the search algorithm to obtain from the set of values an untested value that is lower than the test value, to use as the test value in the next iteration.

6. The system of claim 5, further comprising a current digital-to-analog converter ("IDAC") electrically connected to the controller and to the power amplifier, the IDAC configured to receive the control signal from the controller and, responsively, generate the one or more biasing currents each at a corresponding magnitude indicated by the value of the control signal; and wherein:
the control signal is a DAC code and the set of values are sequentially arranged; and
the search algorithm comprises a binary search of the set of values.

7. The system of any of claims 1 to 6, further comprising a buffer section electrically connected to an input terminal of the power amplifier, the buffer section configured to receive a calibrated power signal and provide the calibrated power signal to the power amplifier for amplification to produce the output signal, the buffer section comprising one or more input buffers and one or more output buffers each receiving the supply voltage and one of the one or more biasing currents, wherein the one or more input buffers, the one or more output buffers, and the power amplifier each comprise one or more cascode amplifiers each comprising:
a common source transistor receiving one of the one or more biasing currents at a gate of the common source transistor; and
a common gate transistor having a source terminal connected to a drain terminal of the common source transistor, the common gate transistor receiving a cascode voltage at a gate of the common gate transistor;
wherein the cascode voltage is equal to the supply voltage minus an offset voltage.

8. The system of claim 7, further comprising:
a low-dropout (LDO) voltage regulator electrically connected to the controller, the buffer section, and the power amplifier, the LDO voltage regulator configured to receive a first control signal from the controller and, responsively, generate the supply voltage corresponding to a value of the first control signal and provide the supply voltage to the one or more input buffers, the one or more output buffers, and the power amplifier;
a cascode voltage generator electrically connected to the LDO voltage regulator, the buffer section, and the power amplifier, the cascode voltage generator configured to receive the supply voltage, generate the cascode voltage based on the supply voltage, and provide the cascode voltage to the one or more cascode amplifiers of each of the one or more input buffers, the one or more output buffers, and the power amplifier; and
a current digital-to-analog converter ("IDAC") electrically connected to the controller, to the buffer section, and to the power amplifier, the IDAC configured to receive a second control signal from the controller and, responsively, generate the one or more biasing currents each at a corresponding magnitude indicated by a value of the second control signal and provide the one or more biasing currents to the one or more cascode amplifiers of each of the one or more input buffers, the one or more output buffers, and the power amplifier.

9. The system of claim 8, wherein the first control signal comprises a LDO code having a corresponding set of values, and the controller is configured to determine a calibrated LDO code that causes the LDO voltage regulator to produce the supply voltage at the calibrated value by sequentially testing the set of values for the LDO code, starting at a minimum value of the set of values.

10. The system of any of claims 8 to 9, wherein the second control signal comprises a DAC code having a corresponding set of values, and the controller is configured to determine a calibrated DAC code that causes the IDAC to produce the one or more biasing currents at the corresponding one or more calibrated magnitudes by testing the set of values for the DAC code using a binary search algorithm.

11. The system of any of claims 8 to 10, further comprising memory accessible by the controller and storing the control logic, the target output power, a first set of values for the first control signal, and a second set of values for the second control signal, and the controller is configured to obtain the corresponding values of the first and second control signals from the memory.

12. The system of any of claims 1 to 11, wherein the detector is a peak-to-peak detector (PPD), the system further comprising a coupler electrically connected to the output terminal of the power amplifier and to an input terminal of the PPD, the coupler configured to output:
at an output port of the coupler, a second output signal that corresponds to the first output signal; and
at a coupled port of the coupler, a coupled output signal corresponding to a coupled portion of the first output signal coupled within the coupler, the coupled output signal also corresponding to an amount of incident power at an antenna reference plane (ARP) of the vehicle radar subsystem;
wherein the detector is electrically connected to the coupled port of the coupler, and is configured to produce the detector signal responsive to the coupled output signal power level.

13. A method of calibrating output power of a power amplifier that amplifies an input signal to produce an output signal, the method comprising:
providing, by a controller in signal communication with a voltage regulator and a current source each electrically connected to one or more amplifiers disposed in a signal chain between the input signal and the output signal, a first control signal having a first value to the current source, the current source being configured to receive the first control signal and to provide, to the one or more amplifiers, one or more biasing currents each at a corresponding magnitude indicated by a value of the first control signal, the first value indicating a corresponding maximum magnitude for each of the one or more biasing currents;
while the one or more biasing currents are at the corresponding maximum magnitude, determining, by the controller, a calibrated value for a second control signal readable by the voltage regulator to provide, to the one or more amplifiers, a supply voltage at a voltage level corresponding to a value of the second control signal, the calibrated value being associated with the voltage level of the supply voltage that causes the output signal to have a power level equal to a target power level;
providing, by the controller, the second control signal with the calibrated value to the voltage regulator;
while the voltage regulator is providing the supply voltage at the voltage level corresponding to the calibrated value of the second control signal, determining, by the controller, a second value for the first control signal that both:
causes the power level of the output signal to equal the target power level; and
corresponds to a sum of the corresponding magnitudes of the one or more biasing currents being less than any other sum of magnitudes of the one or more biasing currents that causes the power level of the output signal to equal the target power level; and
providing, by the controller, the first control signal with the second value to the current source and the second control signal with the calibrated value to the voltage regulator.

14. The method of claim 13, wherein:
the voltage regulator is a low-dropout (LDO) voltage regulator;
the value of the second control signal is selectable from a set of LDO code values ordered sequentially by increasing associated voltage level; and
determining the calibrated value for the second control signal comprises iteratively, starting from the value of the second control signal set to a minimum value of the set of LDO code values and until the calibrated value is stored:
providing the second control signal to the voltage regulator;
obtaining, from a detector in signal communication with the controller and electrically disposed to sample the output signal at an output terminal of the power amplifier, a detector signal corresponding to the power level of the output signal;
determining, based on the detector signal, whether the power level is equal to the target power level;
responsive to a determination that the power level is equal to the target power level, storing the value of the second control signal as the calibrated value; and
responsive to a determination that the power level is not equal to the target power level, incrementing the value of the second control signal.

15. The method of any of claims 13 to 14, wherein:
the current source is a current digital-to-analog converter (DAC) that receives the first control signal at a digital input port and outputs the one or more biasing currents at a corresponding number of output ports;
the value of the first control signal is selectable from a set of DAC code values ordered sequentially by increasing summed magnitude of the one or more corresponding magnitudes of the one or more biasing currents, the first value being a maximum value of the set of DAC code values; and
determining the second value for the first control signal comprises performing a binary search of the set of DAC code values by, beginning with a lower bound of the binary search set to a minimum value of the DAC code values and both the second value and an upper bound of the binary search set to the maximum value of the DAC code values, and until the binary search is complete, iteratively:
obtaining, from the set of DAC code values, a test value that is halfway between the lower bound and the upper bound;
providing the first control signal having the test value to the current DAC;
obtaining, from a detector in signal communication with the controller and electrically disposed to sample the output signal at an output terminal of the power amplifier, a detector signal corresponding to the power level of the output signal;
determining, based on the detector signal, whether the power level is lower than the target power level;
responsive to a determination that the power level is lower than the target power level, setting the lower bound to the test value; and
responsive to a determination that the power level is not lower than the target power level:
setting the upper bound to the test value;
determining whether the power level is equal to the target power level; and
responsive to a determination that the power level is equal to the target power level, resetting the second value to the test value.
